(19) Europäisches Patentamt
European Patent Office
Office européen des brevets

(11) **EP 1 805 881 B1**

(12) **EUROPÄISCHE PATENTSCHRIFT**

(45) Veröffentlichungstag und Bekanntmachung des Hinweises auf die Patenterteilung:
**14.12.2011 Patentblatt 2011/50**

(51) Int Cl.:
***H02M 3/335*** *(2006.01)*

(21) Anmeldenummer: **05803948.8**

(22) Anmeldetag: **13.10.2005**

(86) Internationale Anmeldenummer:
**PCT/DE2005/001831**

(87) Internationale Veröffentlichungsnummer:
**WO 2006/042513 (27.04.2006 Gazette 2006/17)**

(54) **ELEKTRONIKSTROMVERSORGUNG**

POWER SUPPLY FOR AN ELECTRONIC SYSTEM

ALIMENTATION ELECTRONIQUE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **18.10.2004 DE 102004050665**

(43) Veröffentlichungstag der Anmeldung:
**11.07.2007 Patentblatt 2007/28**

(73) Patentinhaber: **MK-Elektronik-GmbH**
**87748 Fellheim (DE)**

(72) Erfinder: **KAUFMANN, Michael**
**87437 Kempten (DE)**

(74) Vertreter: **Pfister, Stefan Helmut Ulrich et al**
**Pfister & Pfister**
**Patent & Rechtsanwälte**
**Hallhof 6-7**
**87700 Memmingen (DE)**

(56) Entgegenhaltungen:
**US-A1- 2003 039 092    US-A1- 2004 174 147**
**US-B1- 6 310 792**

**Beschreibung**

Die Erfindung betrifft eine Elektronikstromversorgung für elektronische Schaltungen mit hoher Betriebsfrequenz. In den vergangenen Jahrzehnten wurde die Rechenleistung von Computern dem "Mooreschen Gesetz" entsprechend in jeweils durchschnittlich anderthalb Jahren verdoppelt. Diese Leistungssteigerung wurde durch immer kleiner werdende Halbleiterstrukturen, folglich zunehmende Integrationsdichte und die dadurch ermöglichte, stetige Steigerung der Taktfrequenz erreicht. Für die Stromversorgung dieser Systeme hatte dies eine schrittweise Reduzierung der Betriebsspannung bei entsprechender Erhöhung des Betriebsstroms zur Folge. Außer der dadurch erforderlichen Steigerung der Regelgenauigkeit stiegen mit der Taktfrequenz zusätzlich die dynamischen Anforderungen an die Stromversorgung erheblich an.

Bei derzeitigen, mit ca. 2 bis 3GHz Taktfrequenz betriebenen Hochleistungsprozessoren darf die Betriebsspannung bei dynamischen Laststromänderungen von ca. 350A/$\mu$s nicht mehr als $\pm$ 5% (ca. $\pm$ 0,05 bis 0,075V) überschwingen, um eine einwandfreie Funktion des Prozessors nicht zu beeinträchtigen.

Bei einer Länge der Stromführungsleitungen von beispielsweise nur 1,5cm bei 1cm Breite und einem Leiterabstand von 1,5mm (doppelt kaschierte Leiterplatte) entsteht eine Leitungsinduktivität von ca. 3nH. Eine dynamische Stromänderung von 350A/$\mu$s induziert damit an der Stromzuführungsleitung bereits Spannungsspitzen von ca. $\pm$ 1V, also ca. $\pm$ 70% der Betriebsspannung bei $U_B$= 1,5V.

Bei derzeitigem Stand der Technik versucht man diese dynamischen Anforderungen mit Point-of-Load-DC/DC-Wandlern hoher Betriebsfrequenz - in aktueller Variation als mehrphasige Abwärtswandler mit Synchrongleichrichtung und digitaler Phasensteuerung und Regelung ausgeführt - sowie einer größeren Anzahl von über die Chipfläche verteilten Stützkondensatoren zu lösen, wobei eine hohe Zahl von über den ganzen Prozessorchip verteilter Stromzuführungskontaktierungen die Zuleitungsinduktivität minimiert.

Um hochkapazitive Stützkondensatoren durch eine geringe Anzahl kleiner Kondensatoren mit geringerem ESR und kleinerer Induktivität ersetzen zu können, werden auch DRC-Schaltungen (Dynamic Load Transient Response Circuit) z.B. der Firma Ericsson oder gemäß US-Patent 6,472,855B2 eingesetzt.

Trotz Anwendung dieser Techniken sind die Bemühungen, die Taktrate weiter zu steigern, an eine physikalische Grenze (in Fachzeitschriften als "Powerproblem" bezeichnet) gestoßen. Die noch im Dezember 2003 für das Jahr 2005 vorhergesagte CPU-Taktfrequenz von 15GHz erscheint bei derzeitigem Stand der Technik unerreichbar. Mit zusätzlichen Designmaßnahmen auf Chipebene, wie der X-Architektur, der Einteilung in mehrere, mit äußeren Stützkondensatoren verbundene Stromversorgungsbezirke, und anderen Maßnahmen konnte allenfalls eine Taktfrequenz von etwa 4GHZ als oberste, auch durch weitere Strukturverkleinerung nicht mehr zu überschreitende Grenzfrequenz erreicht werden.

Weder die bereits mit Strukturbreiten von 90nm erreichbaren Transistorzellen-Grenzfrequenzen von über 70GHz, noch die mögliche thermische Wärmeabfuhr von 1kW/cm$^2$ (bei $\Delta$T $\approx$ 5°C zwischen Chip und Dampftemperatur) bei Verdampfungskühlung (z.B. Heatpipe) werden nach dem derzeitigen Stand der Technik ausgereizt.

Fehlerursachen für unkontrollierbare Systemabstürze bei Überschreitung der derzeit möglichen Taktraten sind die der Taktfrequenz und dem Betriebsstrom proportionalen Betriebsspannungsspitzen (Transienten), die trotz der relativ hohen Zahl der am Chip bondierten Stützkondensatoren ab einer bestimmten Taktfrequenz den noch sicheren Betriebsspannungsbereich von $\pm$ 10% erheblich über- bzw. unterschreiten. Es sind die von Software und Datenfluß abhängigen Bitparitätsschwankungen (Paritätsrauschen) verursachten, dynamischen Änderungen des Betriebsstromes mit der Taktfrequenz, welche an Induktivität und ESR der Stützkondensatoren diese Spannungsspitzen erzeugen.

Rechenbeispiel

mit den Betriebsdaten eines typischen Prozessors, 1,5V Betriebsspannung $U_B$ bei 40A Stromverbrauch, 2GHz Taktfrequenz, 20 Stützkondensatoren Größe 1210 (3,2 x 2,4 x 2,5 mm):

40A/20 $\rightarrow$ 2A/Kondensator $\rightarrow$ bei 1% Stromrauschen mit 0,25ns Pulsbreite ergibt sich eine dynamische Stromänderung von $\pm$ 0,02A/0,25ns $\approx$ $\pm$ 8.10$^7$A/s am stützkondensator.

Bei einem mittleren Kondensatorabstand 2,5mm/2 + 0,25mm vom Chip läßt sich die mit dem Chip gebildete Induktivität über die Formel $L_C = \mu_0 \cdot A/l$ abschätzen:

$$L_C = \mu_0 \cdot 1,5mm \cdot 2,5mm/2,5mm \approx 1,9nH$$

Die an dieser Induktivität vom Stromrauschen induzierte Spannung wird damit:

$$\pm\ 8\cdot10^7 A/s\cdot1,9nH\ \approx\ \pm\ 0,15V$$

Dieser Wert entspricht den für einen fehlerfreien Betrieb gerade noch erlaubten Betriebsspannungsspitzen von $\pm$ 10% $U_B$.

Problemverschärfend kommt hinzu, daß mit zunehmender Integrationsdichte (von 130nm → 90nm → 65nm → 45nm Strukturbreite, letztere der C-Mos-Gatelänge entsprechend) bei steigendem Betriebsstrom die Betriebsspannung von 2V auf 0,9V reduziert werden muß, wobei die Zahl der Stützkondensatoren kaum erhöht, deren Größe und Chipabstand nicht verkleinert werden kann. Dies erklärt die allgemein als "physikalische Grenze" angesehene Barriere für eine weitere Taktfrequenzerhöhung.

Aus der Druckschrift US 6,310,792 B1 ist eine Elektronikstromversorgung bekannt, die für hochfrequent betriebene oder getaktete Integrierte Schaltungen mit Kompensation dynamischer Betriebsstromänderungen vorgesehen ist. Diese Druckschrift betrifft point-of-load-Stromversorgungen nach dem Stand der Technik, bei denen die Elemente zur dynamischen Betriebsspannungsstabilisierung durch Verbindungsleitungen nicht ausreichend offenbarter Länge und Induktivität von den Verbrauchern getrennt sind. Ähnliche Lösungen sind auch aus den Druckschriften US 2003/039092 A1 und US 2004/174147 A1 bekannt. Aufgabe der Erfindung ist es, diese Nachteile direkt am Entstehungsort zu beheben.

Diese Aufgabe wird bei einer Elektronikstromversorgung der eingangs genannten Art erfindungsgemäß durch die Merkmale des Anspruchs 1 gelöst und erreicht, daß dynamische Stromänderungskompensationsschaltungen in unmittelbarer Nähe der Entstehungsorte der Stromänderungen, wie beispielsweise Addierwerken, Cachespeichern, Datenbustreibern u. a., platziert oder in die Integrierte Schaltung selbst integriert werden.

Die Verlagerung der dynamischen Betriebsspannungskonstanthaltung (mittels Stromänderungskompensationsschaltungen) vom Millimeterbereich der Leiterplatte in den Mikrometerbereich der Halbleiter-Chipebene reduziert die Stromleitungsinduktivität zur Last (Stromverbraucherschaltungen) um den gleichen Skalierungsfaktor. Bei gleicher Toleranzbreite für die Betriebsspannungstransienten kann erfindungs-gemäß die Taktfrequenz theoretisch um den reziproken Skalierungs-faktor erhöht werden.

Einfache Stromänderungskompensationsschaltungen lassen sich hierbei z.B. mit wenigen, von der Betriebsspannung kapazitiv gegengekoppelten Transistoren (Millerintegrator), welche der CPU-Betriebsspannung an geeigneten Orten in oder am Halbleiterchip als Shuntregler parallel geschaltet sind, realisieren. Je nach Anwendungsfall lassen sich mit ca. 1 bis 10% Shuntstrom (örtlicher Betriebsstromanteil) alle auftretenden dynamischen Stromänderungen nahezu vollständig ausregeln und auf den Stromzuführungsleitungen zur äußeren Stromversorgung auf ca. 1% der vom IC erzeugten reduzieren.

Die Erfindung besitzt den Vorteil, daß Stromrauschquellen auf den Stromzuführungsleitungen und an den Stützkondensatoren keine den sicheren Betrieb beeinträchtigenden Spannungsspitzen mehr induzieren können. Dies erlaubt neben einer Taktfrequenzerhöhung um ca. den Faktor 10 auch eine Reduzierung der Anzahl von Stützkondensatoren und Speisespannungszuführungskontaktierungen zum Chip um ca. 90%, womit die Herstellungskosten erheblich gesenkt werden können und die Zuverlässigkeit deutlich gesteigert wird. Die Chiparchitektur läßt sich bei Anwendung der Erfindung wieder deutlich vereinfachen, wodurch Designaufwand und Designzeiten erheblich reduziert werden.

Programmabhängige Betriebsstromänderungen von ca. 20% bis 110% mit maximal 3% der Taktfrequenz müssen bei Einhaltung von $U_B$ $\pm$ 10% weiterhin von der Prozessor-Hauptstromversorgung ausgeregelt werden. Um diese Anforderungen auch bei Taktfrequenzen von ca. 25GHz noch erfüllen zu können, wird es notwendig, die Hauptstromversorgung in kleinstmöglicher Entfernung zum Mikroprozessor (also direkt darüber) zu plazieren und diese gegenüber dem derzeitigen Stand der Technik weiter zu optimieren. Eine derartig in den verschiedenen Unterfunktionen optimierte Stromversorgung, die Synergieeffekte dieser Verbesserungen zur Wirkungsgradsteigerung bei erheblicher Erhöhung der Zuverlässigkeit und gleichzeitiger Reduzierung der Herstellungskosten ermöglicht, ist in den folgenden Ausgestaltungen beschrieben.

Eine Ausgestaltung der Erfindung besteht darin, daß die Plazierung der Niederspannungsstromversorgung über dem Chipträger der Integrierten Schaltung erfolgt. Dadurch wird erreicht, daß kürzestmögliche Stromspeiseleitungen zur Integrierten Schaltung eine verkürzte Ausregelzeit der Versorgungsspannung der Integrierten Schaltung ermöglichen. Weiterhin wird dadurch erreicht, daß der bisher auf der Trägerplatine der Integrierten Schaltung für die Stromversorgung benötige Platzbedarf entfällt.

Eine weitere Ausgestaltung besteht darin, daß Integrierte Schaltung und Niederspannungsstromversorgung durch einen gemeinsamen Kühlblock gekühlt werden. Dadurch wird erreicht, daß der Aufwand einer getrennten Kühlung für die Stromversorgung entfällt und ein gemeinsamer Übertemperaturschutz für Last und Versorgung möglich wird. Überdies kann der Kühlblock bei Auslegung als mechanischer Teil der Niederspannungsstromversorgung auch der Stromzuführung zum Verbraucher dienen.

Eine weitere Ausgestaltung besteht darin, daß die Regelung der Niederspannungsstromversorgung primärseitig - mit oder ohne galvanische Trennung - vor der Transformation auf die Versorgungsspannungen der Integrierten Schaltung erfolgt. Dadurch wird erreicht, daß die Regelung bei um das Transformatorübersetzungsverhältnis reduziertem Primärstrom erfolgen kann.. Dies reduziert die Herstellungskosten und erhöht den Wirkungsgrad der Stromversorgung.

Weiterhin wird erreicht, daß bislang benötigte DC-Zwischenkreis-Wandlermodule eingespart werden können, da die Niederspannungsstromversorgung mit galvanischer Trennung direkt am Versorgungs-Bus (z.B. 48V) betrieben werden kann. Weiterhin wird erreicht, daß eine die Integrierte Schaltung gefährdende Versorgungsspannungserhöhung durch Ausfall einer Synchrongleichrichterstufe oder deren Regelung erfindungsgemäß nicht mehr auftreten kann.

Eine weitere Ausgestaltung besteht darin, daß die Streuinduktivität eines Gegentaktwandlertransformators als Speicherinduktivität für die Niederspannungsstromversorgung genutzt wird. Dadurch wird die Einsparung nach bisherigem Stand der Technik zusätzlich nötiger Speicherinduktivitäten erreicht.

Eine weitere Ausgestaltung besteht darin, daß die primärseitige Pulsweitenmodulationsfrequenz ein Vielfaches der Gegentaktwandlerfrequenz beträgt. Dadurch wird erreicht, daß die Schaltfrequenz für die Synchrongleichrichter 20- bis 50-fach niedriger liegt als nach bisherigem Stand der Technik und dadurch entsprechend niedrigere Schaltverluste entstehen.

Eine weitere Ausgestaltung besteht darin, daß die Gegentaktsekundärwicklungen, bestehend aus je einer Doppelwindung, auf den Transformatoraußenschenkeln aufgebracht und bei der Synchrongleichrichtung parallelgeschaltet werden. Dadurch wird erfindungsgemäß bei gleicher Strombelastung die Anzahl der zur Synchrongleichrichtung benötigten Transistoren gegenüber dem bisherigen Stand der Technik halbiert.

Eine weitere Ausgestaltung besteht darin, daß durch leistungsmäßige Überdimensionierung die Stromversorgung zusätzlich als Point-of-Load-Wandler für periphere Schaltungen dienen kann. Dadurch wird erreicht, daß der Platzbedarf für die Stromversorgung peripherer Schaltungen entfällt.

Die Zeichnung veranschaulicht prinzipielle Ausführungsbeispiele der Erfindung, und zwar zeigt:

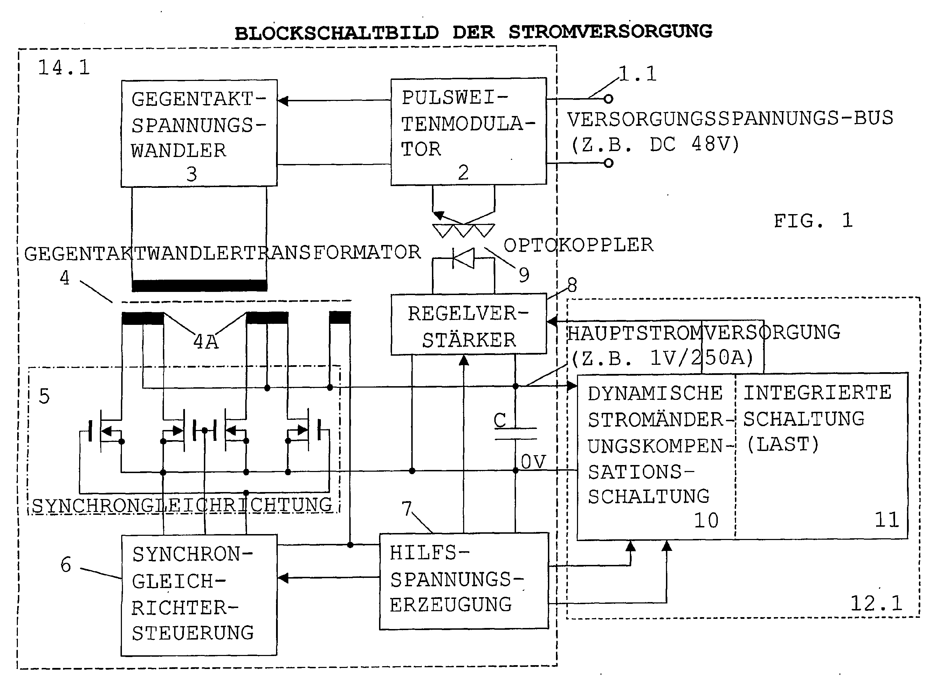

Fig. 1    ein Blockschaltbild der Elektronikstromversorgung mit Kompensation dynamischer Stromänderungen direkt am Entstehungsort

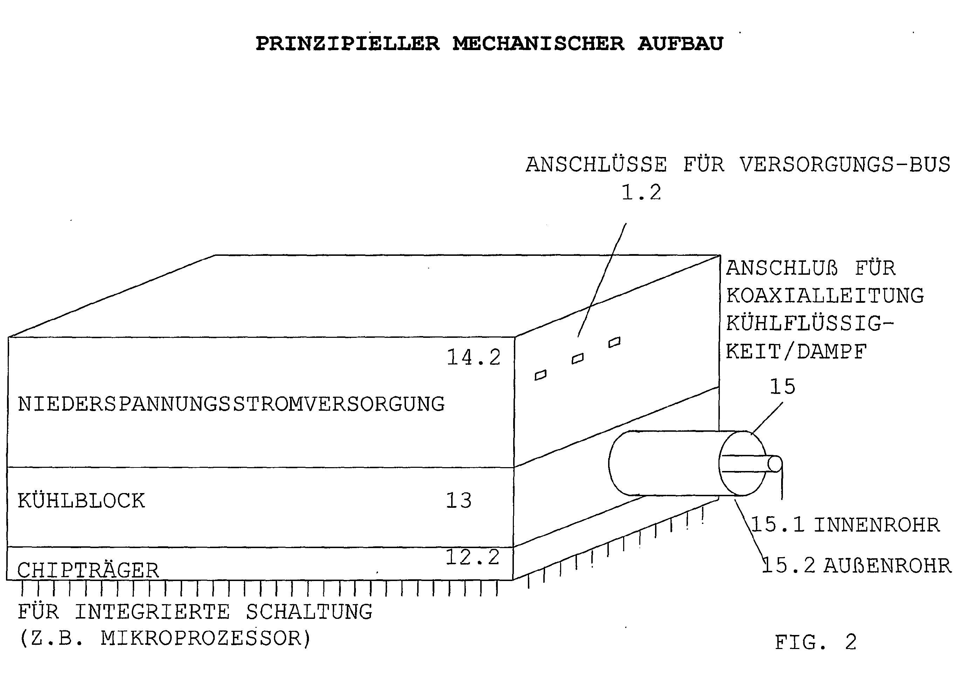

Fig. 2    einen prinzipiellen mechanischen Aufbau von Elektronikstromversorgung und zu speisender Integrierter Schaltung mit gemeinsamer Kühlung

Eine Elektronikstromversorgung benötigt einen Netz- bzw. Versorgungs-BUS-Anschluß (1.1 bzw. 1.2). Die Pulsweitenmodulation (2) bestimmt die Stromaufnahme des Gegentaktspannungswandlers (3). Der Gegentaktspannungswandler (3) formt eine Rechteckspannung aus dem integrierten Mittelwert der Pulsweitenmodulatorausgangsspannung. Mit dem Gegentaktwandlertransformator (4) wird die Gegentaktwandlerausgangsspannung auf die gewünschte Hauptstromversorgungsspannung sowie die benötigten Hilfsspannungen transformiert. Im Synchrongleichrichter (5) werden die transformierten Gegentaktspannungen für die Hauptstromversorgung gleichgerichtet und parallelgeschaltet. Die Hilfsspannungserzeugung (7) wird von einer weiteren Sekundärwicklung auf dem Gegentaktwandlertransformator (4) versorgt. Gleichzeitig dient diese Sekundärwicklung zur Steuerung des Synchrongleichrichters (6). Der von der Hilfsspannungserzeugung (7) gespeiste Regelverstärker (8) vergleicht die Spannung der Hauptstromversorgung mit einer eingebauten Referenz und überträgt die Regelabweichung über einen Optokoppler (9) zur Steuerung des Pulsweitenmodulators (2). Die Hilfsspannungsversorgung (7) speist neben der Hauptstromversorgung auch die Regelelektronik der dynamischen Stromänderungskompensationsschaltung (10). Dadurch werden Änderungen der Spannung an der Last (11) nahezu vollständig ausgeregelt.

Temperaturschutzfunktionen können über ein von der dynamischen Stromänderungskompensationsschaltung (10) oder der Integrierten Schaltung (11) ausgehendes Steuersignal realisiert werden. Bei Erreichen einer unterhalb der Zulässigen Chiptemperatur zu wählenden Größe (z.B. -30K gegenüber maximal zulässiger Chiptemperatur) wird hierbei der Regelverstärker (8) veranlaßt, Hauptstromversorgung und Hilfsspannungen in kontrollierter Weise herunterzufahren. Bei redundanter Auslegung kann es dem Regelverstärker (8) ermöglicht werden, ab Überschreiten einer vorgegebenen Temperatur selbsttätig Hauptstromversorgung und Hilfsspannungen herunterzufahren.

Beim mechanischen Aufbau wird auf dem Chipträger (12.2), der nach oben hin durchkontaktiert sein muß, ein Kühlblock (13) aus elektrisch und thermisch leitfähigem Material (z.B. Kupfer) aufgebracht. Dieser Kühlblock ist segmentiert, um eine positive und negative Stromführung zu ermöglichen, Anschlüsse für Hilfsspannungen werden durch den Kühlblock durchgeführt. Die Transformatorsekundärwicklungen für die Hauptstromversorgung werden von die Transformatoraußenschenkel umschließenden, leitfähigen Formteilen gebildet und mit den Plus und Minus führenden Segmenten des Kühlblocks verbunden und dienen als Träger der Mosfets des Synchrongleichrichters sowie zu deren Wärmeableitung. Kondensatoren (C) überbrücken die Plus und Minus führenden Segmente und wirken als Integrationskondensatoren für die Stromversorgung (14.1) und als Stützkondensatoren für die Last (11) sowie die dynamische Stromänderungskompensationsschaltung (10).

Über Last (11) und dynamischer Stromänderungskompensationsschaltung (10) sind im Kühlblock Verdampfungskammern für die Kühlflüssigkeit angebracht, welche über das Innenrohr (15.1) der Koaxialleitung (15) zugeführt wird. In dampfförmigem Aggregatszustand befindliche Kühlflüssigkeit kann über das Außenrohr (15.2) abgeleitet werden.

**Patentansprüche**

1. Anordnung mit einer hochfrequent betriebenen oder getakteten Integrierten Schaltung (11), insbesondere einem Mikroprozessor, dynamischen Stromänderungskompensationsschaltungen (10), die auf Halbleiter-Chipebene der Integrierten Schaltung der Versorgungsspannung als Shuntregler parallel geschaltet werden, einer Elektronikstromversorgung (14.1) zur Versorgung der Integrierten Schaltung, so dass dynamisch eine Stromänderungskompensation in unmittelbarer Nähe der Entstehungsorte der Stromänderungen im Mikrometerbereich der Halbleiter-Chipebene erfolgt, und so dass die Integrierte Schaltung auf den Stromzuführungsleitungen und an den Stützkondensatoren der Integrierten Schaltung keine den sicheren Betrieb der Integrierten Schaltung beeinträchtigenden Spannungsspitzen induzieren kann.

2. Anordnung nach Anspruch 1, **dadurch gekennzeichnet, dass** die Platzierung der Niederspannungs-Hauptstromversorgung (14.2 mit Kühlblock 13) direkt über dem Halbleiterchip (12.2) so erfolgt, dass verkürzte Stromspeiseverbindungen der Hauptversorgungsspannung für den Halbleiterchip (12.2) ermöglicht werden und der separate Platzbedarf für diese Stromversorgung auf der Trägerplatine entfällt.

3. Anordnung nach einem der vorhergehenden Ansprüche, dadurch gekennnzeichnet, dass der Halbleiterchip (12.2) und die Niederspannungs-Hauptstromversorgung (14.2) durch einen gemeinsamen Kühlblock (13) gekühlt werden, welcher als mechanischer Teil der Niederspannungs-Hauptstromversorgung (14.2) zusätzlich als Stromzuführung zum Halbleiterchip (12.2) dient, sowie Träger für dessen äußere Stützkondensatoren (C) ist.

4. Anordnung nach einem der vorhergehenden Ansprüche, **dadurch gekennzeichnet, dass** die primärseitig vor der Transformation auf die Hauptstromversorgungsspannung (14.1) erfolgende PWM-Spannungsregelung Zwischenkreis-Spannungswandler nach dem Stand der Technik erspart, deutlich Wirkungsgrad und Zuverlässigkeit erhöht bei gleichzeitig erheblich reduzierten Herstellungskosten.

5. Anordnung nach einem der vorhergehenden Ansprüche, **dadurch gekennzeichnet, dass** die Streuinduktivität des Gegentaktwandlertransformators (4) als Speicherinduktivität genutzt wird.

6. Anordnung nach einem der vorhergehenden Ansprüche, **dadurch gekennzeichnet, dass** die Schaltfrequenz der Synchrongleichrichter der Gegentaktwandlerfrequenz entsprechend ca. 20 bis 50-fach niedriger liegt als die (vielfach höhere) primärseitige Pulsbreitenmodulationsfrequenz, so dass gegenüber dem Stand der Technik 20 bis 50-fach niedrigere Schaltverluste bei der Synchrongleichrichtung entstehen.

7. Anordnung nach einem der vorhergehenden Ansprüche, **dadurch gekennzeichnet, dass** die Gegentaktsekundärwicklungen aus je einer Doppelwindung bestehend auf den Transformatoraußenschenkeln (4A) aufgebracht und über die Synchrongleichrichter (5) parallel geschaltet werden, was gegenüber dem Stand der Technik eine Halbierung der Synchrongleichrichter-Transistorzahl ermöglicht (gleiche Strombelastung wie beim Stand der Technik vorausgesetzt), womit auch Raumbedarf und Kosten halbiert werden und der Wirkungsgrad durch eingesparte Halbleiter steigt.

8. Anordnung nach einem der vorhergehenden Ansprüche, **dadurch gekennzeichnet, dass** bei Nutzung der unter Anspruch 2 bis einschließlich 7 beanspruchten Verbesserungen in Synergie neben der Raumersparnis noch eine Leistungsüberdimensionierung (über den Leistungsbedarf des Halbleiterchips 12.2 hinausgehend) ermöglicht wird, um zusätzliche periphere Schaltungen mit Strom zu versorgen und damit die nach dem Stand der Technik dafür nötigen Point-of-Load-Wandler sowie deren Platzbedarf auf der Trägerplatte einzusparen.

9. Anordnung nach einem der vorhergehenden Ansprüche, **dadurch gekennzeichnet, dass** die Anzahl der Stützkondensatoren auf dem Halbleiterchip und die Speisespannungszuführungskontaktierungen zum Halbleiterchip um ca. 90% gegenüber dem Stand der Technik reduziert ist, wobei zusätzlich eine Leistungssteigerung durch Taktfrequenzerhöhung um mehr als den Faktor 10 erfolgen kann.

10. Anordnung nach einem der vorhergehenden Ansprüche, **dadurch gekennzeichnet, dass** die Chiparchitektur vereinfacht ist, was zu kleinerer Chipfläche und entsprechend reduziertem Stromverbrauch führt.

**Claims**

1. Arrangement with a high-frequency operated or clocked integrated circuit (11), in particular a micro processor, dynamic current modification compensation circuits (10) switched parallel on the level of a semiconductor chip of the integrated circuit of the supply voltage as shunt control, an electronic power supply (14.1) for supplying the integrated circuit, so that dynamically a current modification compensation is carried out in the immediate vicinity of the points of origin of the current modifications in the micro meter range of the semiconductor chip level, and so that the integrated circuit cannot induce voltage peaks interfering with the safe operation of the integrated circuit on the power supply lines and at the back-up capacitors.

2. Arrangement according to claim 1, **characterised in that** placing of the low voltage main power supply (14.2 with cooling block 13) directly above the semiconductor chip (12.2) is carried out in such a way that the shortened power feeding connections of the main supply voltage for the semiconductor chip (12.2) become possible, and the separate required space for this power supply is apportioned to the carrier board.

3. Arrangement according to one of the preceding claims, **characterised in that** the semiconductor chip (12.2) and the low voltage main power supply (14.2) are cooled by a common cooling block (13) that serves as mechanic part of the low voltage main power supply (14.2) additionally as power supply to the semiconductor chip (12.2), as well as is carrier for its exterior back-up capacitors (C).

4. Arrangement according to one of the preceding claims, **characterised in that** the PWM voltage control carried out primarily before the transformation to the main power supply voltage (14.1) saves intermediate circuit voltage transformers according to the state of the art, increases clearly efficiency and reliability, while the costs for production are considerably reduced at the same time.

5. Arrangement according to one of the preceding claims, **characterised in that** leakage inductance of the push-pull converter (4) is used as storage inductance.

6. Arrangement according to one of the preceding claims, **characterised in that** the switching frequency of the synchronous rectifier of the push-pull converter frequency is accordingly about 20 to 50 times lower than the (much higher) primary pulsewidth modulation frequency, so that, compared with the state of the art, 20 to 50 times lower switching losses occur during the synchronous rectifying.

7. Arrangement according to one of the preceding claims, **characterised in that** the push-pull secondary windings, each comprising a double winding, are applied on the transformer outer limbs (4A), and are connected parallel via the synchronous rectifiers (5), what cuts the number of synchronous rectifier transistors in two, compared with the state of the art, (if the current load is the same as in the state of the art), so that also the required space and the costs are cut in two, and the efficiency increases through saved semiconductors.

8. Arrangement according to one of the preceding claims, **characterised in that**, when the improvements in synergy claimed in claims 2 to 7 are used, besides the saved space also an over-dimensioning of performance (exceeding the required performance of semiconductor chips 12.2) becomes possible, to supply additional peripheral circuits with power, and thus to save the point-of-the-load converters required according to the state of the art, as well as their required space on the carrier board.

9. Arrangement according to one of the preceding claims, **characterised in that** the number of supporting capacitors on the semiconductor chip and the feeding voltage supply contacts to the semiconductor chip is reduced by about 90% compared with the state of the art, wherein additionally an increase of the performance can be carried out by an increase of the clock frequency by more then the factor 10.

10. Arrangement according to one of the preceding claims, **characterised in that** the chip architecture is simplified what leads to a smaller chip surface and accordingly reduced power consumption.

**Revendications**

1. Montage comportant un circuit intégré (11) utilisant une horloge interne ou externe à haute fréquence comme un microprocesseur, des circuits de compensation dynamique des variations de courant (10) situés à proximité du circuit intégré semi-conducteur montés en parallèle à l'alimentation du circuit intégré comme un shunt réglable, et une alimentation électronique (14.1) alimentant le circuit intégré de façon à ce que la compensation des variations de courant est effectuée au niveau du circuit intégré semi-conducteur à une distance de quelque microns seulement des sources des variations de courant afin d'éviter la génération de pointes de tension par le circuit intégré sur les pistes des son alimentation ou aux bornes de ses condensateurs de découplage pouvant poser un problème de fiabilité de son fonctionnement.

**2.** Montage selon la revendication 1, **caractérisé en ce que** l'alimentation principale en basse tension (14.2 avec bloc de refroidissement 13) est située directement au dessus du circuit intégré semi-conducteur (12.2) de façon à rendre possible l'utilisation de connexions d'alimentation en courant raccourcies, destinées à l'alimentation principale du circuit intégré semi-conducteur (12.2), économisant ainsi de la place sur la platine de support pour cette alimentation en courant.

**3.** Montage selon une des deux revendications précédentes, **caractérisé en ce que** le circuit intégré semi-conducteur (12.2) et son alimentation principale basse tension sont refroidis par un bloc de refroidissement commun (13) faisant partie des éléments mécaniques de l'alimentation principale basse tension (14.2) et servant comme moyen d'alimentation en courant du circuit intégré semi-conducteur (12.2) ainsi que comme support aux condensateurs extérieurs de découplage (C).

**4.** Montage selon une des revendications précédentes, **caractérisé en ce que** l'introduction d'un régulateur de tension de type MLI dans le circuit primaire en amont de la transformation permet d'économiser des transformateurs de tension intermédiaires selon l'état de l'art et augmente considérablement le rendement et la fiabilité tout en réduisant considérablement les coûts de fabrication.

**5.** Montage selon une des revendications précédentes, **caractérisé en ce que** l'inductance parasite du transformateur du convertisseur de type push-pull (4) est utilisée comme inductance de stockage.

**6.** Montage selon une des revendications précédentes, **caractérisé en ce que** la fréquence de commutation des redresseurs commandés correspondant à la fréquence du convertisseur de type push-pull est 20 à 50 fois plus faible que la fréquence primaire à largeur d'impulsion modulée (beaucoup plus élevée) résultant alors, lors du redressement commandé, en des pertes de commutation 20 à 50 fois inférieures à celles des solutions de l'état de l'art.

**7.** Montage selon une des revendications précédentes, **caractérisé en ce que** chacun des enroulements secondaires du transformateur de type push-pull est constitué d'un double enroulement autour d'une des branches extérieurs (4A) et est connecté en parallèle via le redresseur commandé (5), ce qui permet de diviser par deux le nombre de transistors du redresseur commandé par rapport à l'état de l'art (en supposant une charge en courant identique à celle de l'état de l'art) et également de réduire à la moitié l'espace et les coûts tout en augmentant le rendement électrique par diminution du nombre de composants semi-conducteurs utilisés.

**8.** Montage selon une des revendications précédentes, **caractérisé en ce que** l'utilisation des améliorations revendiquées par des revendications de 2 jusqu'à 7 incluses, permet en synergie avec une économie d'espace un surdimensionnement en puissance (au-delà de la puissance consommée par le circuit intégré semi-conducteur 12.2) et ainsi d'offrir une alimentation supplémentaire des circuits périphériques et ainsi d'économiser des convertisseurs point-of-load et l'espace nécessaire sur la platine mère.

**9.** Montage selon une des revendications précédentes, **caractérisé en ce que** le nombre de condensateurs de découplage situés au niveau du circuit intégré semi-conducteur et le nombre de contacts d'alimentation du circuit intégré semi-conducteur sont réduits d'environ 90% par rapport à l'état de l'art, et **en ce qu'**une augmentation de la performance du circuit intégré à l'aide d'une augmentation de la fréquence d'horloge d'au moins un facteur 10, est possible.

**10.** Montage selon une des revendications précédentes, **caractérisé en ce que** l'architecture du circuit intégré est simplifiée, ce qui résulte en une surface du circuit intégré plus petite et ainsi en une réduction de la consommation correspondante.

# BLOCKSCHALTBILD DER STROMVERSORGUNG

14.1

GEGENTAKT-
SPANNUNGS-
WANDLER
3

PULSWEI-
TENMODULA-
TOR
2

1.1

VERSORGUNGSSPANNUNGS-BUS
(Z.B. DC 48V)

FIG. 1

GEGENTAKTWANDLERTRANSFORMATOR

OPTOKOPPLER

4

4A

9

8

REGELVER-
STÄRKER

HAUPTSTROMVERSORGUNG
(Z.B. 1V/250A)

5

C

DYNAMISCHE
STROMÄNDER-
UNGSKOMPEN-
SATIONS-
SCHALTUNG
10

INTEGRIERTE
SCHALTUNG
(LAST)

11

0V

SYNCHRONGLEICHRICHTUNG

6

SYNCHRON-
GLEICH-
RICHTER-
STEUERUNG

7

HILFS-
SPANNUNGS-
ERZEUGUNG

12.1

EP 1 805 881 B1

8

**PRINZIPIELLER MECHANISCHER AUFBAU**

ANSCHLÜSSE FÜR VERSORGUNGS-BUS
1.2

ANSCHLUß FÜR
KOAXIALLEITUNG
KÜHLFLÜSSIG-
KEIT/DAMPF

15

14.2

NIEDERSPANNUNGSSTROMVERSORGUNG

KÜHLBLOCK                13

12.2

CHIPTRÄGER

15.1 INNENROHR

15.2 AUßENROHR

FÜR INTEGRIERTE SCHALTUNG
(Z.B. MIKROPROZESSOR)

FIG. 2

EP 1 805 881 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6472855 B2
- US 6310792 B1
- US 2003039092 A1
- US 2004174147 A1